# EUROPEAN PATENT APPLICATION

(11) **EP 4 531 099 A1**
(43) Date of publication of application: **02.04.2025**
(21) Application number: 24199670.1
(22) Date of filing: 11.09.2024
(51) Int. Cl.: H01L 23/46, H01L 23/00, H01L 25/065

(54) **DISTRIBUTION OF COOLING ACROSS MULTIPLE SUBSTRATES OR DIE**

(30) Priority: 28.09.2023 US 202363586133 P; 11.06.2024 US 202418740155
(71) Applicant: Avago Technologies International Sales Pte. Limited, Singapore 768923 (SG)
(72) Inventor: Theil, Jeremy, San Jose 95134 (US)
(74) Representative: Dilg, Haeusler, Schindelmann Patentanwaltsgesellschaft mbH

(57) **Abstract**

Novel tools and techniques are provided for implementing a semiconductor package or a chip package, and more particularly methods, systems, and apparatuses are provided for implementing a semiconductor package or a chip package including a substrate comprising a first channel, a first die coupled to the first substrate and comprising at least a first portion of a second channel, and a first opening extending from the first channel to the second channel.

## Description

### CROSS-REFERENCE TO RELATED APPLICATION

This application generally relates to semiconductor technologies.

### COPYRIGHT STATEMENT

A portion of the disclosure of this patent document contains material that is subject to copyright protection. The copyright owner has no objection to the facsimile reproduction by anyone of the patent document or the patent disclosure as it appears in the Patent and Trademark Office patent file or records, but otherwise reserves all copyright rights whatsoever.

### FIELD

The present disclosure relates, in general, to methods, systems, and apparatuses for implementing a semiconductor device comprising a channel.

### BACKGROUND

For high power density semiconductor devices, it can be advantageous to extract the generated heat from either the front side or the back side of the semiconductor device, substrate, die, or the like. In some instances, in order to extract the heat, one or more fluids can be used for heat transfer. In order to deliver fluids to the front side or the back side of the semiconductor device, substrate, die, or the like, channels can be placed near one or more active regions of the semiconductor device, substrate, die, or the like. By providing channels near the one or more active regions of the semiconductor device, substrate, die, or the like, it is possible to minimize the thermal resistance between heat source and the cooling fluid and provide cooling to the one or more active regions.

In multi-die or multi-substrate modules, it can be difficult to deliver the cooling fluid between the two or more dies, two or more substrates, between a substrate and a die, between a substrate and another component, between a die and another component, or the like.

Hence, there is a need for more robust and scalable solutions for implementing semiconductor packages and chip packages with channels. Thus, methods, systems, and apparatuses are provided for implementing semiconductor packages or chip packages including one or more channels extending across or between multiple components of a semiconductor device.

### BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.
FIG. 1 is a top view of the semiconductor device showing one or more channels in dotted shaded areas located between the substrate and the one or more die of the semiconductor device, in accordance with various embodiments;
FIGS. 3A and 3B are cross-sectional views of the semiconductor device of FIG. 2 taken along line A-A, in accordance with various embodiments;
FIG. 4 shows another cross-sectional view of another embodiment of a semiconductor device, in accordance with various embodiments;
FIG. 5 shows another cross-sectional view of another embodiment of a semiconductor device, in accordance with various embodiments;
FIG. 6 is a cross-sectional view of the semiconductor device of FIG. 2 taken along line B-B, in accordance with various embodiments;
FIG. 7 shows another cross-sectional view of another embodiment of a semiconductor device, in accordance with various embodiments;
FIG. 8 shows another cross-sectional view of another embodiment of a semiconductor device, in accordance with various embodiments;
FIG. 9 shows another cross-sectional view of another embodiment of a semiconductor device, in accordance with various embodiments;
FIG. 10 shows another cross-sectional view of another embodiment of a semiconductor device, in accordance with various embodiments; and
FIG. 11 is a flow diagram of a method of fabricating a semiconductor device, in accordance with various embodiments.

### DETAILED DESCRIPTION OF EMBODIMENTS

Various embodiments provide tools and techniques for implementing semiconductor packages or chip packages including one or more channels are described herein.

In a first aspect, a semiconductor device can include a substrate comprising a first channel, a first die coupled to the substrate and comprising at least a first portion of a second channel, and a first opening extending from the first channel to the second channel and fluidly coupling the first channel to the second channel.

In some embodiments, at least one of the substrate further comprises a first layer or the first die comprises a second layer and the first opening can extend from the first channel to the second channel through at least one of the first layer or the second layer. In various cases, at least one of the first layer or the second layer comprises a dielectric layer. In some instances, at least one of a first surface of the first layer is coupled directly to a second surface of the first die or the second layer or a third surface of the second layer is coupled directly to a fourth surface of the substrate or the first layer.

In various instances, the semiconductor device further includes an interface between the substrate and the first die. The interface can couple a first surface of the substrate directly to a second surface of the first die and the first opening extending from the first channel to at least the first portion of the second channel can extend through the interface. In various cases, the interface can be formed using at least one of surface activated bonding or hybrid bonding. In some instances, the interface is configured to form a seal surrounding the first opening extending from the first channel to at least the first portion of the second channel. The semiconductor device can also include a fluid contained within the first channel and the second channel and the fluid can be configured to pass from the first channel to the second channel via the first opening.

In some cases, the opening is about a same size as a bottom surface of the second channel.

In various embodiments, the second channel is formed in the first die and a bottom surface of the second channel is a top surface of the substrate.

In some instances, a second portion of the second channel is at least partially formed within the substrate and the second portion of the second channel is in fluid communication with at least the first portion of the second channel.

In various cases, the second channel is fully contained within the first die and the first die forms a bottom surface of the second channel. In some instances, the substrate further comprises an other first channel and the semiconductor device further comprises a second opening. The first opening can extend from the first channel to the second channel at a first location and the second opening can extend from the other first channel to the second channel at a second location. The second channel can bridge the first channel and the other first channel.

In some embodiments, the substrate further comprises an other first channel and the semiconductor device further comprises a second opening. The first opening can extend from the first channel to the second channel at a first location and the second opening can extend from the other first channel to the second channel at a second location. The second channel can bridge the first channel and the other first channel.

In various instances, the semiconductor device can further include a second die coupled to the first die and comprising at least a portion of a third channel. The first die can be between the substrate and the second die. In some embodiments, a third opening can extend from the first channel to the third channel through the first die or can extend from the second channel to the third channel. The semiconductor device can further include a fourth opening extending from the third channel to at least a portion of a fourth channel contained within the first die or another first die.

In some cases, the semiconductor device further comprises a port coupled to the first channel. The port can be configured to allow fluid to flow into or out of the first channel.

In another aspect, a method of manufacturing a semiconductor device can include forming a substrate comprising forming a first channel in the substrate and forming a first layer on the substrate and forming a first opening extending from the first channel through the first layer. The first layer can include an interface configured to couple directly to a surface of a die comprising at least a first portion of a second channel.

In some embodiments, the method can further include forming the die comprising forming at least the first portion of the second channel in the die and coupling the substrate to the surface of the die via the interface. In some instances, the first opening extends from the first channel to the second channel and fluidly couples the first channel to the second channel.

In yet another aspect, a semiconductor device can include a substrate comprising a first channel, a die coupled to the substrate and comprising at least a first portion of a second channel, a first opening extending from the first channel to the second channel, and a fluid contained within the first channel and the second channel and configured to flow between the first channel and the second channel via the first opening.

In the following description, for the purposes of explanation, numerous details are set forth to provide a thorough understanding of the described embodiments. It will be apparent to one skilled in the art, however, that other embodiments may be practiced without some of these details. Several embodiments are described herein, and while various features are ascribed to different embodiments, it should be appreciated that the features described with respect to one embodiment may be incorporated with other embodiments as well. By the same token, however, no single feature or features of any described embodiment should be considered essential to every embodiment of the invention, as other embodiments of the invention may omit such features.

When an element is referred to herein as being "connected," "coupled," or "attached" to another element, it is to be understood that the elements can be directly connected or coupled to the other element, or have intervening elements present between the elements. In contrast, when an element is referred to as being "directly connected," "directly coupled," or "directly attached" to another element, it should be understood that no intervening elements are present in the "direct" connection or coupling between the elements. However, the existence of a direct connection or coupling does not exclude other connections or couplings, in which intervening elements may be present. As used throughout this disclosure, "connect," "connected," etc. can refer to a connection (e.g., electrical connection between one or more elements while "couple," "coupled," etc. can refer to a connection (e.g., mechanical or physical connection, link, or engagement) between one or more elements.

When an element is referred to herein as being "disposed" or "located" in some manner relative to another element (e.g., disposed on, disposed between, disposed under, disposed adjacent to, or disposed in some other relative manner), it is to be understood that the elements can be directly disposed or located relative to the other element (e.g., disposed directly on another element), or have intervening elements present between the elements. In contrast, when an element is referred to as being "disposed directly" or "located directly" relative to another element, it should be understood that no intervening elements are present in the "direct" example. However, the existence of a direct disposition does not exclude other examples in which intervening elements may be present.

Likewise, when an element is referred to herein as being a "layer," it is to be understood that the layer can be a single layer or include multiple layers. For example, a conductive layer may comprise multiple different conductive materials, multiple layers of different conductive materials, dielectric materials, or the like, and a dielectric layer may comprise multiple dielectric materials, multiple layers of dielectric materials, conductive materials, or the like. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components. Additionally, terms such as first, second, third, are merely used to distinguish elements or components from each other and are not intended to imply an order, sequence, or amount unless expressly stated otherwise.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." The term "substantially" or "about" used herein refers to variations from the reference value or ratio of ± 20% or less (e.g., ± 20%, 10%, ± 5%, etc.), inclusive of the endpoints of the range.

In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

In existing semiconductor or chip packages, one or more channels, cavities, or voids are often formed to deliver a cooling fluid to one or more active regions of a substrate, die, or other component of a semiconductor device. However, these channels are typically limited to one die, or other component of the semiconductor device. In semiconductor devices comprising multiple substrates, multiple dies, or multiple other components, it is not possible to have a channel, cavity, or void that can deliver a cooling fluid within or between each of the multiple substrates, multiple dies, or multiple other components.

The subject technology comprises a semiconductor or chip device (e.g., integrated circuit (IC), chip, or other semiconductor device or module) or interposer (e.g., an interface routing one or more electrical connections between at least two layers or the like) that provides one or more channels (e.g., channels, cavities, voids, openings, etc.). The semiconductor device can include one or more channels configured to provide a single path between multiple substrates, multiple dies, or multiple other components. For example, one or more openings or ports can be configured between one or more first channels of a first substrate and one or more second channels of a die or second substrate. One or more direct bonding interfaces or layers or zero-clearance bonding interfaces or layers can be used to at least partially, substantially, or fully seal the one or more openings or channels and prevent fluid from leaking between the first substrate and the die or the second substrate. Providing one or more channels fluidly connected between the substrate and the die or second substrate provides the advantage of passing cooling fluids to the die when the die is attached to the substrate as a separate part. Further, cooling fluids can flow between multiple die attached to the substrate. Further, providing one or more second channels within the die or second substrate provides the advantage of being able to customize the one or more channels to maximize heat transfer or heat flow.

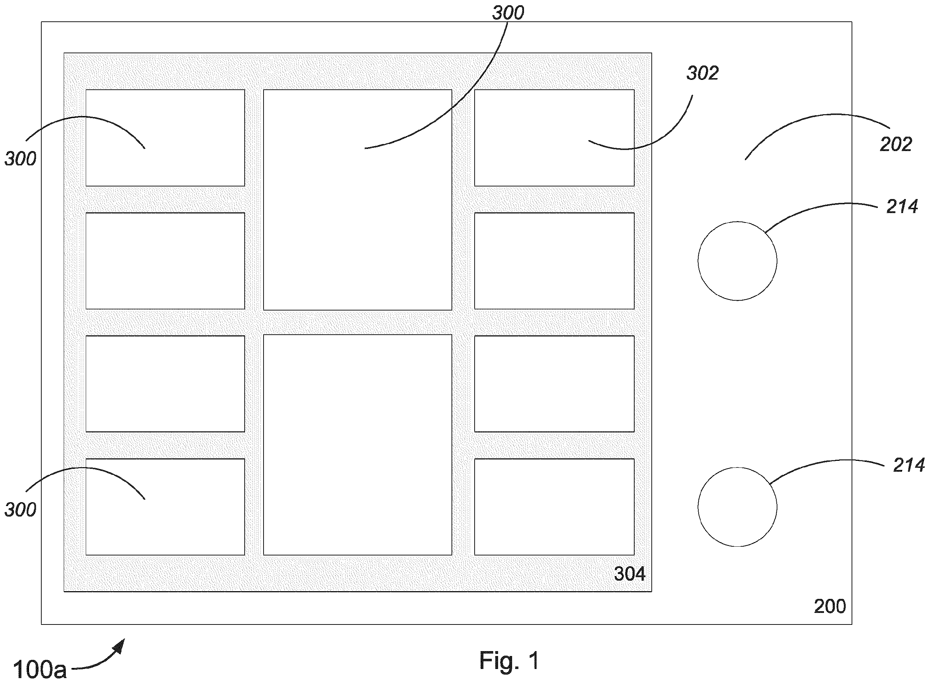

FIG. 1 is a schematic top view of an embodiment of a semiconductor device 100a, in accordance with various embodiments.

The semiconductor device 100a can include a substrate 200. The substrate 200 can be a supporting material (e.g., silicon, glass, ceramic, metal, conductive material, and/or any other semiconductor material or combination of materials) upon which or within which elements or components (e.g., connectors, circuits, integrated circuits, passive devices, active devices, or the like) are fabricated or coupled. The one or more passive devices can be one or more circuit components (e.g., conductors, resistors, capacitors, inductors, etc.) which can transmit, absorb, and/or dissipate power. The one or more active devices can be one or more circuit components (e.g., transistors, or the like) that can control the flow of power. In various cases, the substrate 200 can be formed from one or more layers. The one or more layers can include, without limitation, one or more dielectric layers, one or more device layers, one or more conducting layers, one or more insulating layers, one or more redistribution layers, and/or the like.

In some cases, the substrate 200 can be a packaging substrate, an interposer between two other substrates or semiconductor components, a circuit board such as a printed circuit board, or another substrate configured to provide a supporting material upon which or within which elements or components of the semiconductor device are fabricated or coupled.

The semiconductor device 100a can further include a first row or stack 302 of one or more dies 300 (e.g., one or more first dies 300). The one or more dies 300 can be coupled to a top surface 202 of the substrate 200. In some cases, instead of the one or more dies 300, there could be an other substrate similar to the substrate 200. The other substrate could have many similar features described below with respect to the one or more dies 300.

The one or more dies 300 can include, without limitation, one or more electronic dies, one or more electronic circuits, one or more electronic integrated circuits (EICs), one or more photonic dies, one or more photonic circuits, one or more photonic integrated circuits (PICs), one or more active devices, one or more passive devices, one or more dummy die (e.g., die that are used to take up space, provide support, or the like), or other components or the like. The one or more dies 300 can include one or more layers (not shown). The one or more layers can include, without limitation, one or more dielectric layers, one or more device or circuit layers, one or more conducting layers, one or more insulating layers, one or more redistribution layers, other layers, and/or the like. The layers may further include one or more layers configured to provide component interconnections. In some embodiments, the one or more dies 300 can include, without limitation, a processing circuit (e.g., a central processing unit, a microprocessor, or the like), a switch circuit (e.g., a switch application specific integrated circuit (ASIC) or the like), an input/output circuit, a memory circuit, a circuit configured to receive one or more optical signals, a voltage regulator, a capacitor, passive wires, or the like. As shown in FIG. 1, there are ten dies 300, however, there could be more or less dies depending on the semiconductor device and the semiconductor device 100a is not intended to be limited to only the dies shown.

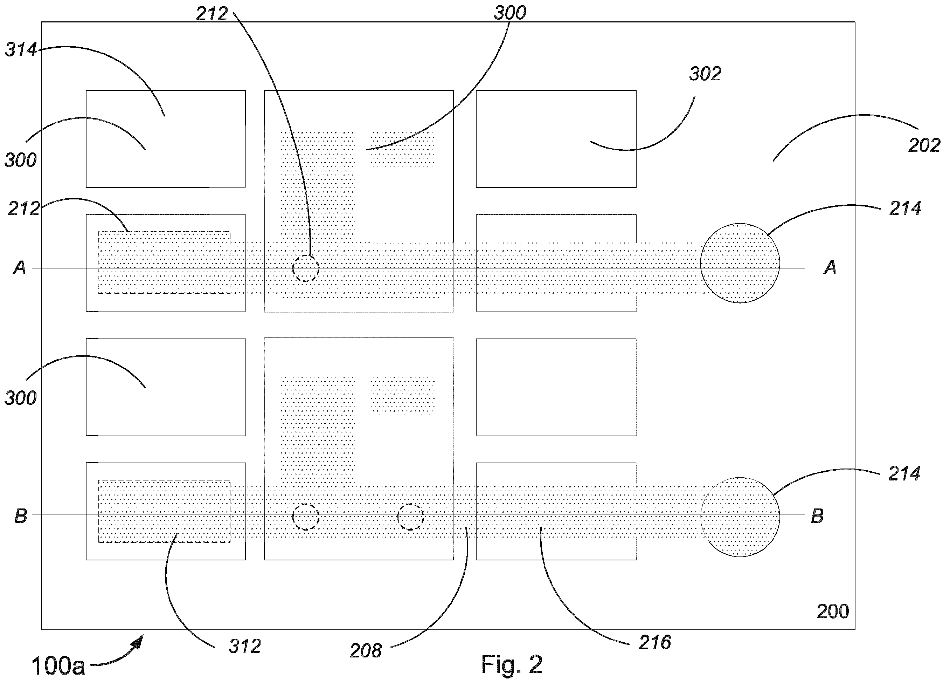

In various cases, a molding compound 304 indicated by the shaded gray area of FIG. 1 can be included between the one or more dies 300. The molding compound can be an epoxy or other material or combinations of material configured to insulate the one or more dies 300 from each other. The molding compound 304 can be configured to insulate the one or more dies 300 from each other or couple the one or more dies 300 to the top surface 102 of the substrate. However, in some cases, the molding compound 304 might not be included between the one or more dies 300 as shown in FIG. 2 or may only be included at selected locations between the one or more dies 300.

Turning to FIG. 2, FIG. 2 is a top view of the semiconductor device 100a of FIG. 1 showing one or more channels in dotted shaded areas located between the substrate 200 and the one or more die 300 of the semiconductor device 100a.

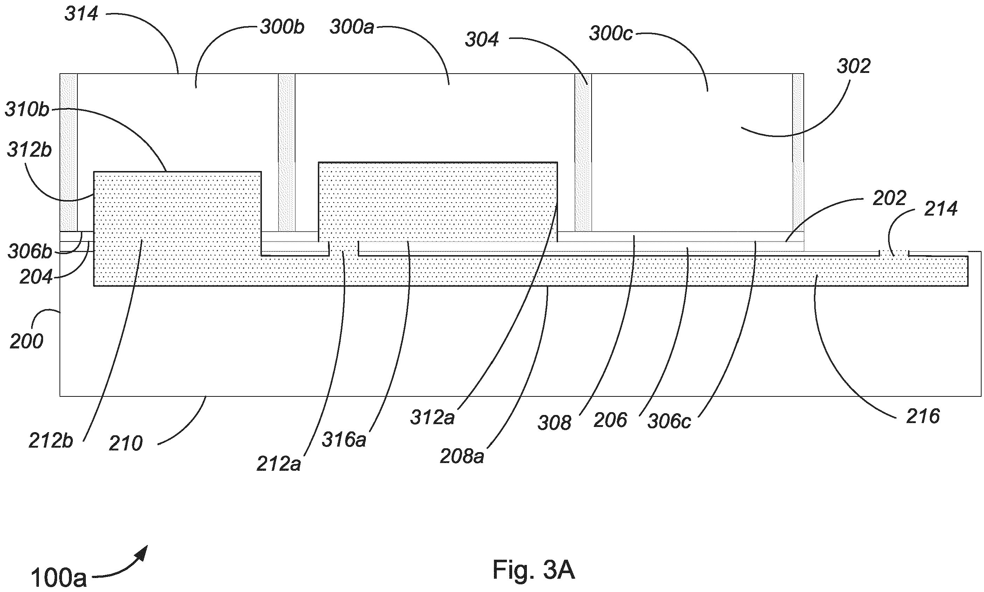

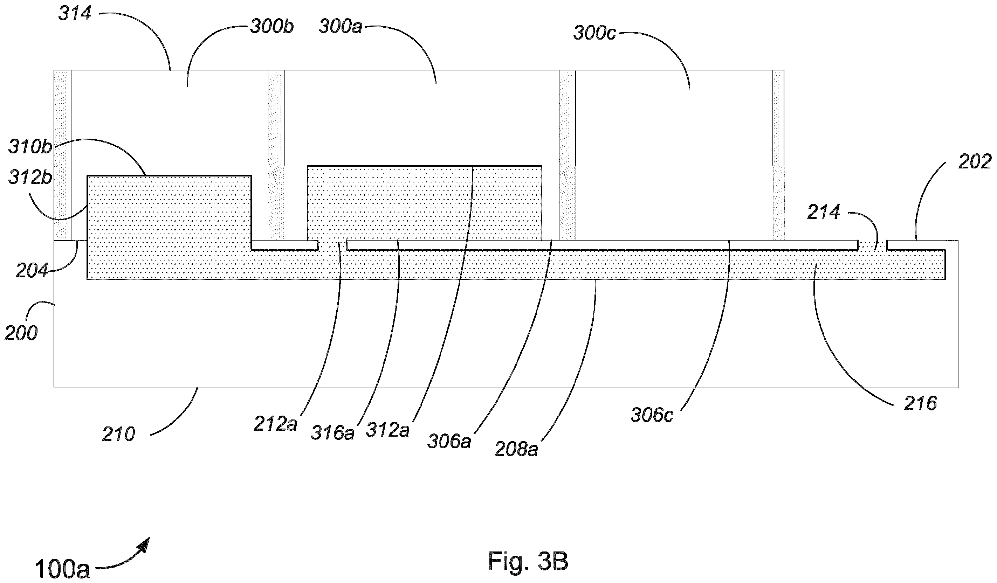

In various cases, the substrate 200 or the one or more dies 300 can comprise an interface 204 between the substrate 200 and the one or more dies 300. In some cases, the interface 204 may be located on either the top surface 202 of the substrate or a bottom surface 306 of the one or more dies 300. In other cases, the interface 204 may be located on both the top surface 202 of the substrate 200 and the bottom surface 306 of the one or more dies 300. The interface 104 can be formed from one or more first layers 206 or one or more second layers 308 which are shown in FIG. 3A. Although the one or more first layers 206 or one or more second layers 308 are not shown in FIGS. 3B-11, there could be one or more first layers 206 or one or more second layers 308 in those embodiments of the semiconductor device as well.

The interface 204, one or more first layers 206, or the one or more second layers 308 can include having a bonding surface (e.g., a surface of the interface 204, one or more first layers 206, or the one or more second layers 308, or the like) that is directly bonded or coupled to another different bonding surface. In some cases, the one or more bonding surfaces can include one or more zero-clearance bonding surfaces (e.g., the top surface 202 and the bottom surface 306, or the like) or substantially zero-clearance bonding surfaces such as one or more hybrid bonding surfaces, one or more direct bonding surfaces, one or more surface activated bonding surfaces, or the like. In some cases, two or more zero-clearance bonding surfaces can be directly bonded together using one or more hybrid bonding surfaces, one or more direct bonding surfaces, one or more surface activated bonding surfaces, or the like. The one or more hybrid bonding surfaces can include directly bonding two or more surfaces that have more than one material (e.g., a combination of an insulator or dielectric material and a conductive material, or the like). The one or more direct bonding surfaces can include directly bonding two surfaces together without intermediate layers between the two surfaces. The one or more surface activated bonding surfaces can comprise bonding (e.g., directly bonding or the like) two or more surfaces that are chemically treated or treated with a plasma process to enhance bond energy between the one or more surfaces.

It is important to note that the bonding surfaces, "zero-clearance" bonding surfaces, or substantially zero-clearance bonding surfaces described above can include situations where there is no clearance or substantially no clearance between the two bonding surfaces or where there is some clearance between the two bonding surfaces. In other words, in each of these bonding situations, zero-clearance bonding situations, or substantially zero-clearance bonding situations, the bonding surfaces, zero-clearance bonding surfaces, or substantially zero-clearance bonding surfaces can be directly coupled to another bonding surface and can be bumpless between the bonding surfaces. As used herein, "bumpless" means without solder bumps, microbumps, or the like between the bonding surfaces. By directly coupling the bumpless bonding surfaces together, this allows the top surface 202 of the substrate 200 and the bottom surface 306 of the one or more dies 300 to sit substantially or fully flush (e.g., without gaps or substantially without gaps between the top surface 202 and the bottom surface 306) against or on top of each other. Thus, the top surface 202 of the substrate 200 and the bottom surface 306 of the one or more dies 300 can be directly bonded together without gaps or substantially without gaps and can be bumpless between the top surface 202 and the bottom surface 306.

A height or plane of a top surface 202 of the substrate 200 could be substantially uniform or substantially flat (e.g., bumpless and without gaps or substantially without gaps between the top surface 202 and the bottom surface 306) in order to ensure that the top surface 202 of the substrate can be bonded (e.g., directly bonded, zero-clearance bonded or the like) to a bottom surface 306 of the one or more dies 300.

In some instances, the substrate 200 can further include one or more first channels 208 while the one or more dies 300 can include at least a first portion 310 of one or more second channels 312. The one or more first channels 208 or second channels 312 are denoted by the dotted shaded areas of FIG. 2. The one or more first channels 208 or the one or more second channels 312 can be located between a bottom surface 210 of the substrate 200 and a top surface 314 of the one or more die 300.

The one or more first channels 208 or second channels 312 can contain or be configured to contain a fluid 216 denoted by the dotted shaded areas of FIGS. 3-10. The fluid 216 could be water or other cooling fluid configured to cool one or more active regions (e.g., regions of the substrate 200 or one or more dies 300 comprising one or more active devices, or the like) or active devices of the substrate 200 or the one or more dies 300. The fluid 216 could also be used to cool other areas of the semiconductor device 100 (such as one or more areas where heat is an issue or the like) and should not be limited to only cooling the one or more active regions or active devices of the substrate 200 or the one or more dies 300. The one or more first channels 208 or the one or more second channels 312 can further comprise one or more ridges, one or more fins, one or more pillars, or other features or components to control the flow of the fluid within the one or more first channels 208 or second channels 312 and to enhance heat transfer between active regions, active devices, or other components of the semiconductor device and the fluid.

In various cases, by directly bonding or coupling the substrate 200 to the one or more dies 300, for example, by using one or more zero-clearance bonding surfaces between the substrate 200 and the one or more dies 300, the bonding surfaces between the substrate 200 and the one or more dies 300 or zero-clearance bonding surfaces between the substrate 200 and the one or more dies 300 can be used to create at least a partial, a substantial, or a full seal directly or indirectly between the top surface 202 of the substrate 200 and the bottom surface 306 of the one or more dies 300. The seal can be used to prevent the fluid 216 contained within the one or more first channels 208 or the one or more second channels 312 from leaking to other areas of the substrate 200 or dies 300. For example, the seal can prevent the fluid from contacting one or more interconnects or other metal features (not shown) between the substrate 200 and the one or more dies 300.

In various cases, the substrate 200 can also include one or more openings 212, shown by the dashed lines in FIG. 2. The one or more openings 212 can be configured to extend at least partially through the substrate 200. The one or more openings 212 can be configured to fluidly couple the one or more first channels 208 and the one or more second channels 312 and allow a fluid (e.g., a cooling fluid, a heating fluid, or other type of fluid, or the like) to move or flow between the one or more first channels 208 and the one or more second channels 312. As used herein, fluidly coupled or fluidly connected means that fluid is able to flow from one component to another. For example, fluid is able to flow between the one or more first channels 208 and the one or more second channels 312 via the one or more openings 212. In this way, the fluid contained within the one or more first channels 208, the one or more second channels 312, and the one or more openings 212 can be advantageously delivered to parts of the substrate 200 or one or more dies 300 that need to be cooled, heated, or the like. In various cases, the one or more openings 212 can be various shapes such as circle-shaped, oval-shaped, square-shaped, rectangle-shaped, polygon-shaped, irregular polygon-shaped, or other shapes. In some cases, there can be multiple openings 212 extending from the first channel 208 to the second channel 312. Alternatively, there may be only one opening extending from the first channel 208 to the second channel 312. In some cases, the one or more openings 212 can be substantially smaller than a bottom surface of the one or more second channels 312 or one or more dies 300. In some cases, the one or more openings 212 may be about the same size as the bottom surface of the one or more second channels 312 or one or more dies 300.

In various cases, the substrate 200 can also include one or more ports 214 coupled to the one or more first channels 208. In some cases, the one or more ports 214 could be included on the one or more dies 300 (not shown) and coupled to the one or more second channels 312. The one or more ports 214 can be configured to extend at least partially through the substrate 200 or one or more dies 300. The one or more ports 214 can be configured to allow the cooling fluid to move or flow into or out of the one or more first channels 208 or the one or more second channels 312. In various cases, the one or more ports 214 can be various shapes such as circle-shaped, oval-shaped, square-shaped, rectangle-shaped, polygon-shaped, irregular polygon-shaped, or other shapes. In some cases, there can be multiple ports 214. Alternatively, there may be only one port 214.

Turning to FIGS. 3A and 3B, FIGS. 3A and 3B are a cross-sectional views of FIG. 2 taken along line A-A. FIG. 3A shows various configurations of the one or more first channels 208 and the one or more second channels 312 arranged within the substrate 200 and the one or more dies 300. FIG. 3B shows a similar cross-sectional view as FIG. 3 without the one or more first layers 206 or one or more second layers 308. However, as stated above, the cross-section of FIG. 3B could include or not include the one or more first layers 206 or one or more second layers 308.

Turning to Example A of the FIGS. 3A and 3B, Example A shows a first channel 208a configured to transmit or receive a fluid 216 to or from a port 214. The first channel 208a can be configured to extend across the substrate 200 and fluidly couple to a second channel 312a of a die 300a via an opening 212a. In this case, the opening 212a is substantially smaller than a bottom surface 316a of the second channel. In various cases, as shown in Example A, the second channel 312a can be fully contained within the die 300a. In various cases, as shown in Example A, one or more first layers 206, a top surface 202 of the substrate 200, or a top surface 202 of the first layer 206 can be a bottom surface 316a of the second channel 312a. In some cases, the top surface 202 of the substrate 200 or first layer 206 or the bottom surface 306a of the die 300a or second layer 308 can include one or more bonding surfaces (e.g., zero-clearance bonding surfaces, substantially zero-clearance bonding surfaces, direct bonding surfaces, or the like), as discussed above, the bonding surfaces can be configured to seal the first channel 208a, the second channel 312a, and the opening 212a and prevent the fluid 216 from leaking to other portions of the semiconductor device 100a.

Turning to Example B of the FIGS. 3A and 3B, Example B shows the first channel 208a fluidly coupled to a second channel 312b of a die 300b via an opening 212b. In this example, the opening 212b is about the same size as the second channel 312b or about the same size or substantially the same size as a bottom surface 306b of the die 300b. In various cases, as shown in Example B, the second channel 312b can extend between the substrate 200 and the die 300b such that only a first portion 310b of the second channel 312b is contained within the die 300b. In some cases, the top surface 202 of the substrate 200 or the bottom surface 306b of the die 300b can include one or more bonding surfaces, as discussed above, the bonding surfaces can be configured to seal the first channel 208a, the second channel 312b, and the opening 212b and prevent the fluid from leaking to other portions of the semiconductor device 100a.

Turning to Example C of the FIGS. FIGS. 3A and 3B, Example C shows the first channel 208a flowing under the die 300c. In this example, there is no second channel and the first channel can be used to cool a bottom surface 306c of the die 300c. In some cases, die 300c may not need any cooling at all and, in that case, the first channel 208 can be routed around the die 300c.

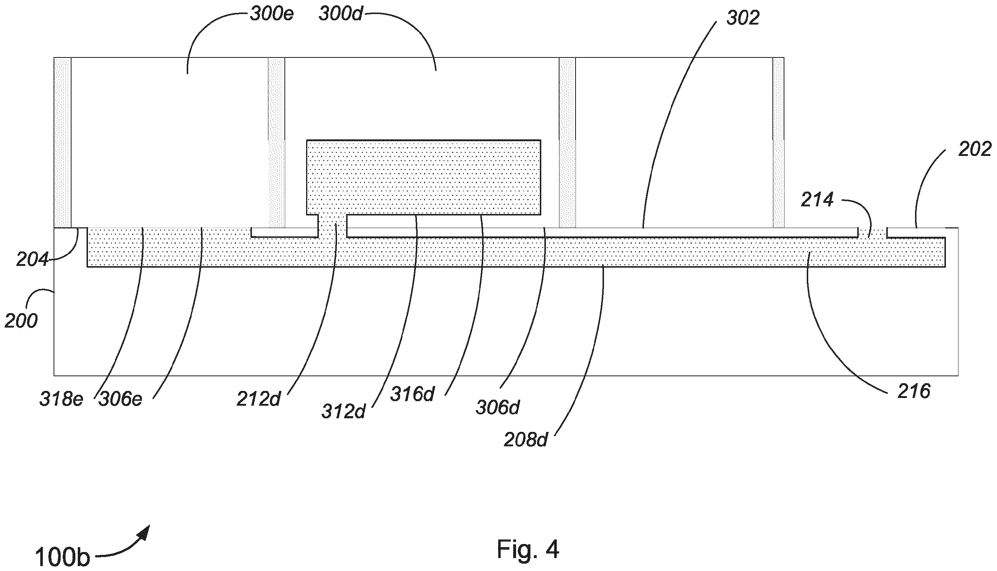

FIG. 4 shows another cross-sectional view of another embodiment of a semiconductor device 100b. The semiconductor device 100b could be similar to the semiconductor device 100a. However, the setup of the one or more first channels 208 and the one or more second channels 312 could be different. FIG. 4 does not show the one or more first layers 206 or the one or more second layers 308. However, as stated above, the cross-section of FIG. 4 could include or not include the one or more first layers 206 or one or more second layers 308.

Turning to Example D of FIG. 4, Example D shows a first channel 208d configured to transmit or receive a fluid 216 to or from a port 214. The first channel 208d can be configured to extend across the substrate 200 and fluidly couple to a second channel 312d of a die 300d via an opening 212d. The opening 212d can extend from the first channel 208 to the second channel 312d through the substrate 200 and the die 300d. In this case, the opening 212d is substantially smaller than a bottom surface 316d of the second channel 312d. In various cases, as shown in Example D, the second channel 312d can be fully contained within the die 300d. In various cases, a portion of the die 300d can be a bottom surface 316d of the second channel 312d. In some cases, the top surface 202 of the substrate 200 or the bottom surface 306d of the die 300a can include one or more bonding surfaces, as discussed above, the bonding surfaces can be configured to seal the first channel 208d, the second channel 312d, and the opening 212d and prevent the fluid from leaking to other portions of the semiconductor device 100b.

Turning to Example E of the FIG. 4, Example E shows the first channel 208d flowing under the die 300e. In this example, there is no second channel and the first channel can be used to cool a bottom surface 306e of the die 300e. Further, in Example E, a bottom surface 308e of the die 300e is configured or one or more second layers 308 are configured as a top surface 318e of the first channel 208d. In some cases, the top surface 202 of the substrate 200 or the bottom surface 306e of the die 300e can include one or more bonding surfaces, as discussed above, the bonding surfaces can be configured to seal the first channel 208d and prevent the fluid from leaking to other portions of the semiconductor device 100b.

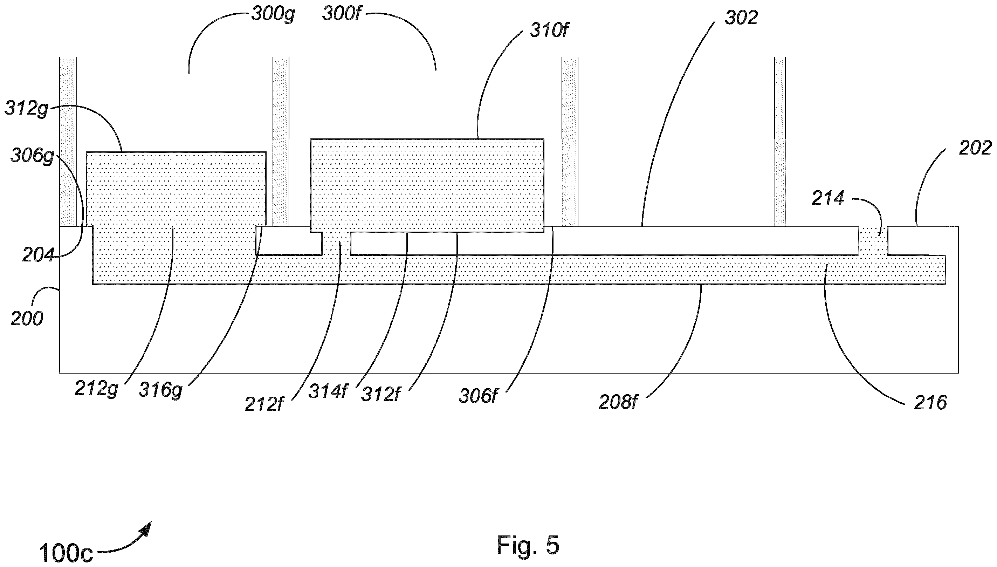

FIG. 5 shows another cross-sectional view of another embodiment of a semiconductor device 100c. The semiconductor device 100c could be similar to the semiconductor device 100a. However, the setup of the one or more first channels 208 and the one or more second channels 312 could be different. FIG. 5 does not show the one or more first layers 206 or the one or more second layers 308. However, as stated above, the cross-section of FIG. 5 could include or not include the one or more first layers 206 or one or more second layers 308.

Turning to Example F of FIG. 5, Example F shows a first channel 208f configured to transmit or receive a fluid 216 to or from a port 214. The first channel 208f can be configured to extend across the substrate 200 and fluidly couple to a second channel 312f of a die 300f via an opening 212f. The opening 212f can extend from the first channel 208 to the second channel 312f through the substrate 200. In various cases, as shown in Example F, the second channel 312f can extend between the substrate 200 and the die 300f such that only a portion 310f of the second channel 312f is contained within the die 300f. In some cases, the top surface 202 of the substrate 200 or the bottom surface 306f of the die 300f can include one or more bonding surfaces, as discussed above, the bonding surfaces can be configured to seal the first channel 208f, the second channel 312f, and the opening 212f and prevent the fluid from leaking to other portions of the semiconductor device 100c.

Turning to Example G of FIG. 5, Example G shows the first channel 208f fluidly coupled to a second channel 312g of a die 300g via an opening 212g. In this example, the opening 212g is substantially the same size as an opening of the second channel 312g. In various cases, as shown in Example G, the second channel 312g can be fully contained within the die 300g and a top surface 202 of the substrate 200 can be a bottom surface 316g of the second channel 312g. In some cases, the top surface 202 of the substrate 200 or the bottom surface 306g of the die 300g can include one or more bonding surfaces, as discussed above, the bonding surfaces can be configured to seal the first channel 208f, the second channel 312g, and the opening 212g and prevent the fluid from leaking to other portions of the semiconductor device 100c.

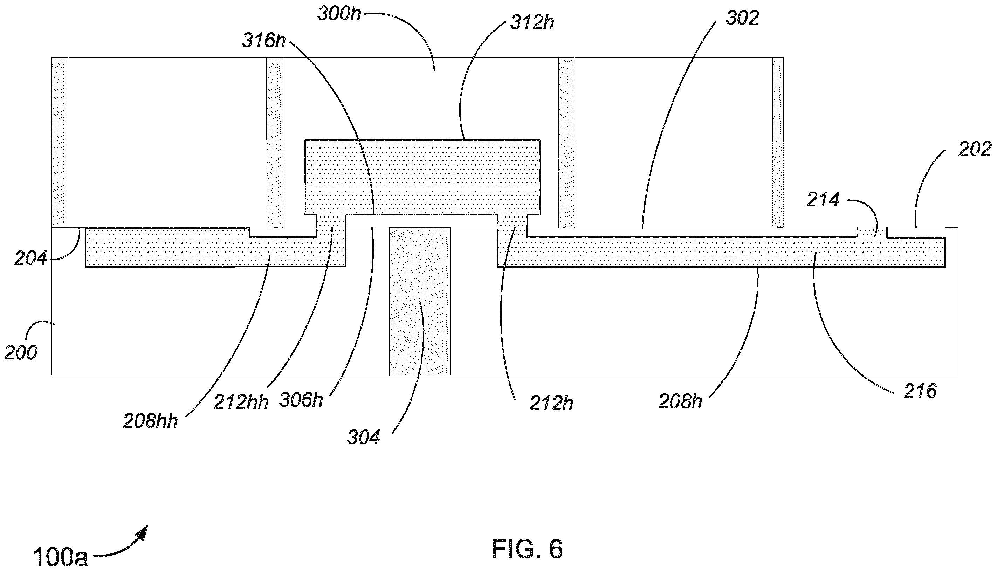

FIG. 6 shows another cross-sectional view of the embodiment of the semiconductor device 100a of FIG. 2 taken along line B-B. FIG. 5 does not show the one or more first layers 206 or the one or more second layers 308. However, as stated above, the cross-section of FIG. 5 could include or not include the one or more first layers 206 or one or more second layers 308.

Turning to Example H of FIG. 6, Example H shows a first channel 208h configured to transmit or receive a fluid 216 to or from a port 214. The first channel 208h can be configured to extend across a portion of the substrate 200 and fluidly couple to a second channel 312h of a die 300h via an opening 212h. The opening 212h can extend from the first channel 208h to the second channel 312h through the substrate 200 and the die 300h. In this case, the opening 212h is substantially smaller than a bottom surface 316h of the second channel 312h. In some cases, the second channel 312h can be a bridge between the first channel 208h and another first channel 208hh. In other words, the second channel 312h can fluidly couple the first channel 208h to the other first channel 208hh via an other opening 212hh extending through the substrate 200 and the die 300h. In this case, the other opening 212hh is substantially smaller than a bottom surface 314h of the second channel 312h. In some cases, the other opening 212hh can be about the same size or the same shape as the opening 212h or can be a different size or different shape than the opening 212h. In various cases, the second channel 212h can be fully contained within the die 300h. This embodiment is beneficial especially when there is a molding compound 304, air, or other component of the semiconductor device 100d located within the substrate 200 between the first channel 208h and the other first channel 208hh. In this way, fluid in the second channel 312h can be routed around the molding compound 304, air, or other component of the semiconductor device 100d and prevented from contacting molding compound 304, air, or other component of the semiconductor device 100d. If the fluid were to contact the molding compound, the fluid could cause the molding compound 304 to dissolve, or the like. In some cases, the top surface 202 of the substrate 200 or the bottom surface 306h of the die 300h can include one or more bonding surfaces, as discussed above, the bonding surfaces can be configured to seal the first channel 208h, the second channel 312h, and the opening 212h, the other first channel 208hh, or the other opening 212hh and prevent the fluid from leaking to other portions of the semiconductor device 100a.

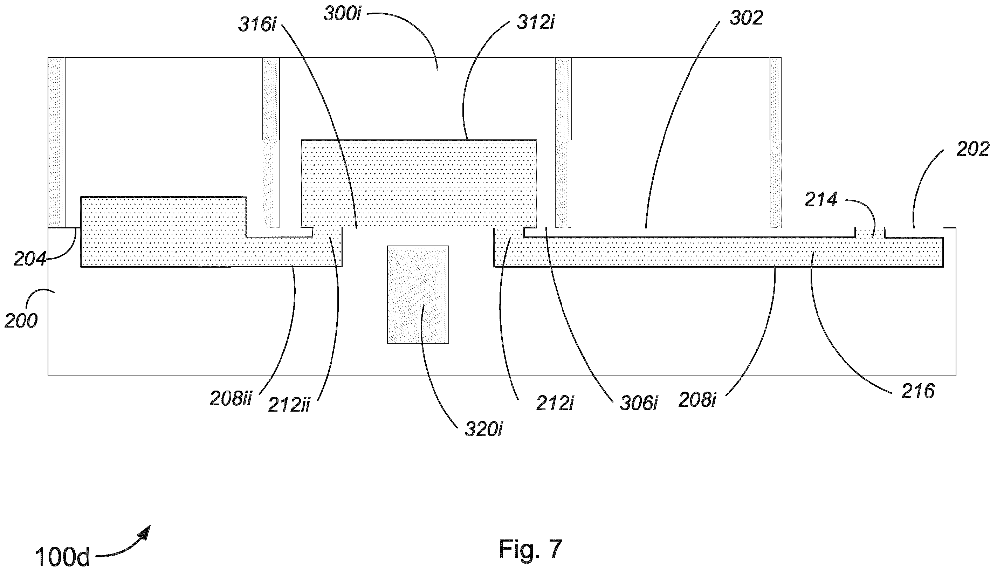

FIG. 7 shows another cross-sectional view of another embodiment of a semiconductor device 100d. The semiconductor device 100d could be similar to the semiconductor device 100a. However, the setup of the one or more first channels 208 and the one or more second channels 312 could be different. FIG. 7 does not show the one or more first layers 206 or the one or more second layers 308. However, as stated above, the cross-section of FIG. 7 could include or not include the one or more first layers 206 or one or more second layers 308.

Turning to Example I of FIG. 7, Example I shows a first channel 208i configured to transmit or receive a fluid 216 to or from a port 214. The first channel 208i can be configured to extend across a portion of the substrate 200 and fluidly couple to a second channel 312i of a die 300i via an opening 212i. The opening 212i can extend from the first channel 208i to the second channel 312i through the substrate 200. In some cases, the second channel 312i can be a bridge between the first channel 208i and another first channel 208ii. In other words, the second channel 312i can fluidly couple the first channel 208i to the other first channel 208ii via an other opening 212ii extending through the substrate 200. In this case, the other opening 212ii is substantially smaller than a bottom surface 314i of the second channel 312i. In various cases, the second channel 312i can be fully contained within the die 300i. However, a top surface 202 of the substrate 200 can be a bottom surface 316i of the second channel 312i. This embodiment is beneficial especially when there is another component 320i (e.g., a molding compound 304, air, or other component) of the semiconductor device 100d located within the substrate 200 between the first channel 208i and the other first channel 208ii. In some cases, the top surface 202 of the substrate 200 or the bottom surface 306i of the die 300i can include one or more bonding surfaces, as discussed above, the bonding surfaces can be configured to seal the first channel 208i, the second channel 312i, the opening 212i, the other first channel 208ii, or the other opening 212ii and prevent the fluid from leaking to other portions of the semiconductor device 100d.

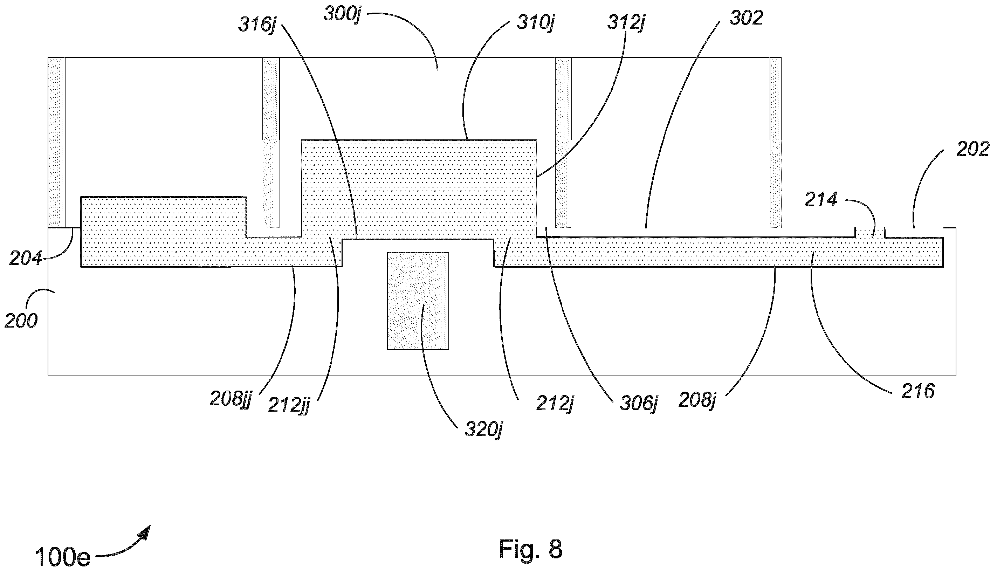

FIG. 8 shows another cross-sectional view of another embodiment of a semiconductor device 100e. The semiconductor device 100e could be similar to the semiconductor device 100a. However, the setup of the one or more first channels 208 and the one or more second channels 312 could be different. FIG. 8 does not show the one or more first layers 206 or the one or more second layers 308. However, as stated above, the cross-section of FIG. 8 could include or not include the one or more first layers 206 or one or more second layers 308.

Turning to Example J of FIG. 8, Example J shows a first channel 208j configured to transmit or receive a fluid 216 to or from a port 214. The first channel 208j can be configured to extend across a portion of the substrate 200 and fluidly couple to a second channel 312j of a die 300j via an opening 212j. The opening 212j can extend from the first channel 208i to the second channel 312j through the substrate 200. In some cases, the second channel 312j can be a bridge between the first channel 208j and another first channel 208jj. In other words, the second channel 312j can fluidly couple the first channel 208j to the other first channel 208jj via an other opening 212jj extending through the substrate 200. In various cases, the second channel 312j can extend between the substrate 200 and the die 300j such that only a portion 310j of the second channel 312j is contained within the die 300j. This embodiment is beneficial especially when there is another component 320j of the semiconductor device 100d located within the substrate 200 between the first channel 208j and the other first channel 208jj. In some cases, the top surface 202 of the substrate 200 or the bottom surface 306j of the die 300j can include one or more bonding surfaces, as discussed above, the bonding surfaces can be configured to seal the first channel 208j, the second channel 312j, the opening 212j, the other first channel 208jj, the other opening 212jj and prevent the fluid from leaking to other portions of the semiconductor device 100e.

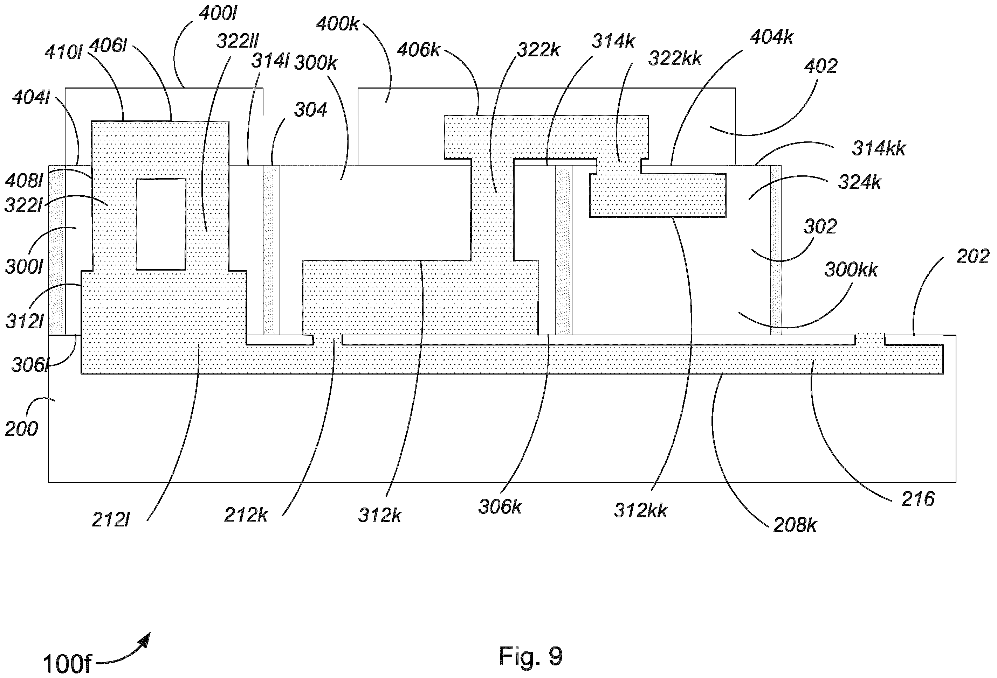

FIG. 9 shows another cross-sectional view of another embodiment of a semiconductor device 100f. The semiconductor device 100f could be similar to the semiconductor device 100a. However, the setup of the semiconductor device 100f such as the setup of the one or more first channels 208, the one or more second channels 312, or one or more dies, or the like could be different. FIG. 9 does not show the one or more first layers 206 or the one or more second layers 308. However, as stated above, the cross-section of FIG. 9 could include or not include the one or more first layers 206 or one or more second layers 308.

The semiconductor device 100f could have a first row or stack 302 of one or more first dies 300 and a second row or stack 402 of one or more second dies 400. The one or more second dies 400 can be similar to the one or more first dies 300 and stacked on top of the one or more first dies 300. A height or plane of a top surface 314 of the first row or stack 302 of the one or more dies 300 and the molding compound 304 could be substantially uniform or substantially flat in order to ensure that the top surface 314 of the one or more dies 300 can be bonded (e.g., zero-clearance bonded, directly bonded, or the like) to a bottom surface 404 of the one or more dies 400. In various cases, not shown, there could be one or more layers similar to the one or more first layers 206 or the one or more second layers 308 between the first row or stack 302 of the one or more dies 300 and the second row or stack 402 of one or more other dies 400.

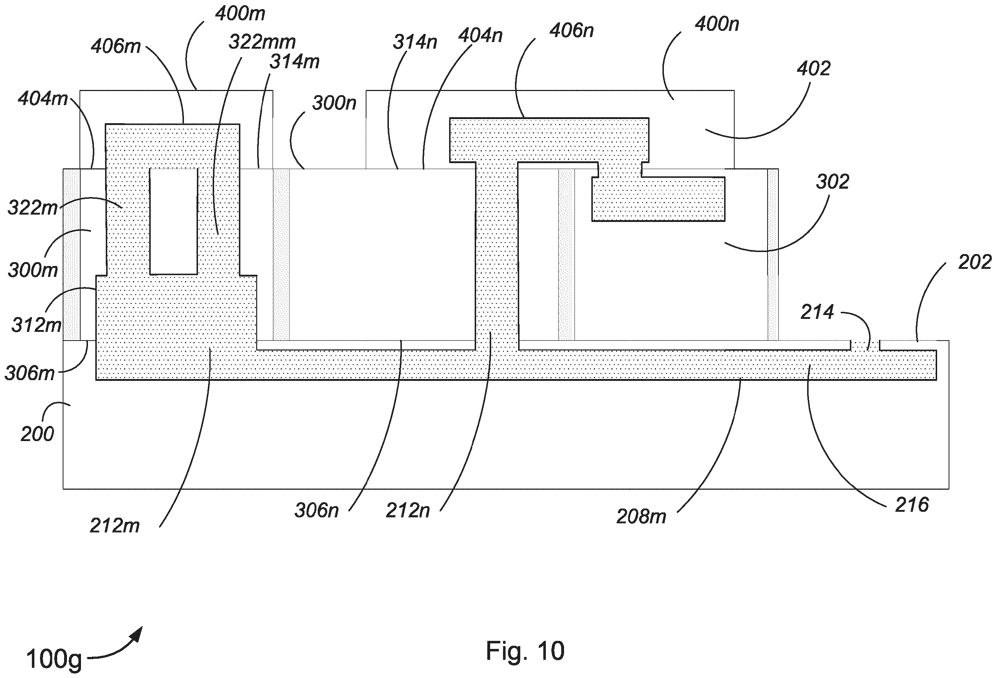

Turning to Example K of FIG. 9, Example K shows a first channel 208k configured to transmit or receive a fluid 216 to or from a port 214. The first channel 208k can be configured to extend across the substrate 200 and fluidly couple to a second channel 312k of a die 300k via an opening 212k. The opening 212k can extend from the first channel 208k to the second channel 312k through the substrate 200. In some cases, the second channel 312k can include a second opening 322k extending from the second channel 312k to a third channel 406k of another die 400k stacked on top of the die 300k. The third channel 406k can function as a bridge between the die 300k and another die 300kk and include another second opening 322kk extending between the third channel 406k and another second channel 312kk. It should be noted that the third channel 406k and the other second channel 312kk can have similar features or functions as discussed above with respect to the one or more second channels and only a few possible embodiments are shown in FIGS. 9 and 10. The other second channel 312kk can be configured to deliver the fluid 216 to a top portion 324k of the other die 300kk. In some cases, the top surface 202 of the substrate 200 or the bottom surface 306k of the die 300k can include one or more bonding surfaces, as discussed above, the bonding surfaces can be configured to seal the first channel 208k, the second channel 312k, and the opening 212k and prevent the fluid from leaking to other portions of the semiconductor device 100f. Additionally, in some cases, the top surface 314k of the die 300k, the bottom surface 404k of the die 400k, or the top surface 314kk of the other die 300kk can include one or more bonding surfaces, as discussed above, the bonding surfaces can be configured to seal the second channel 312, the third channel 406k, the second opening 322k, the other second opening 322kk, or the other second channel 312kk and prevent the fluid from leaking to other portions of the semiconductor device 100f.

Turning to Example L of FIG. 9, Example L shows a first channel 208k configured to transmit or receive a fluid 216 to or from a port 214. The first channel 208k can be configured to extend across the substrate 200 and fluidly couple to a second channel 3121 of a die 3001 via an opening 2121. The opening 2121 can extend from the first channel 208k to the second channel 312k through the substrate 200. In some cases, the second channel 312k can include a second opening 3221 extending from the second channel 312k to a third channel 4061 of another die 4001 stacked on top of the die 3001. The third channel 4061 can be configured to have a first potion 4081 of the third channel 4061 within the die 3001 and a second portion 4101 of the third channel 4061 within the die 4001. The third channel 4061 can function as a bridge between the second opening 3221 and another second opening 32211 extending between the third channel 4061 and the second channel 3121. The second opening 3221 and the other second opening 32211 can be configured to deliver fluid to various locations (e.g., active regions, other areas requiring cooling, or the like) of the die 3001. In some cases, the top surface 202 of the substrate 200 or the bottom surface 3061 of the die 300k can include one or more bonding surfaces, as discussed above, the bonding surfaces can be configured to seal the first channel 208k, the second channel 3121, and the opening 2121 and prevent the fluid from leaking to other portions of the semiconductor device 100f. Additionally, in some cases, the top surface 3141 of the die 3001 or the bottom surface 4041 of the die 4001 can include one or more bonding surfaces, as discussed above, the bonding surfaces can be configured to seal the second channel 3121, the third channel 4061, the second opening 3221, or the other second opening 32211, and prevent the fluid from leaking to other portions of the semiconductor device 100f.

Examples A-M are only some of the arrangements that are possible with the one or more first channels 208, the one or more second channel 312, the one or more openings 212, the one or more third channels 406, or the one or more openings 322, and many other arrangements are possible and are within the scope of the embodiments. Each of the channels or openings can be arranged to deliver a cooling fluid to portions of the substrate 200, one or more dies 300, or one or more dies 400, or other rows of dies or substrate where there are active regions or other components that need to be cooled. In various cases, the one or more first channels 208, the one or more second channel 312, the one or more openings 212, the one or more third channels 406, or the one or more openings 322, or the like can be arranged in any arrangement as required by design, without limitation.

FIG. 10 shows another cross-sectional view of another embodiment of a semiconductor device 100g. The semiconductor device 100g could be similar to the semiconductor device 100f. However, the setup of the semiconductor device 100g such as the setup of the one or more first channels 208, the one or more second channels 312, or one or more dies, or the like could be different. FIG. 10 does not show the one or more first layers 206 or the one or more second layers 308. However, as stated above, the cross-section of FIG. 10 could include or not include the one or more first layers 206 or one or more second layers 308.

Turning to Example M of FIG. 10, Example M shows a first channel 208m configured to transmit or receive a fluid 216 to or from a port 214. The first channel 208m can be configured to extend across the substrate 200 and fluidly couple to a second channel 312m of a die 300m via an opening 212m. The opening 212m can extend from the first channel 208m to the second channel 312m through the substrate 200. In some cases, the second channel 312k can include a second opening 322m extending from the second channel 312m to a third channel 406m of another die 400m stacked on top of the die 300m. A bottom portion 412m of third channel 406m can be a top surface 314m of the die 300m. The third channel 406m can function as a bridge between the second opening 322m and another second opening 322mm extending between the third channel 406m and the second channel 312m. The second opening 322m and the other second opening 322mm can be configured to deliver fluid to various locations (e.g., active regions, other areas requiring cooling, or the like) of the die 300m. In some cases, the top surface 202 of the substrate 200 or the bottom surface 306m of the die 300m can include one or more bonding surfaces, as discussed above, the bonding surfaces can be configured to seal the first channel 208m, the second channel 312m, and the opening 212m and prevent the fluid from leaking to other portions of the semiconductor device 100g. Additionally, in some cases, the top surface 314m of the die 300m or the bottom surface 404m of the die 400m can include one or more bonding surfaces, as discussed above, the bonding surfaces can be configured to seal the second channel 312m, the third channel 406m, the opening 322m, or the other opening 322mm, and prevent the fluid from leaking to other portions of the semiconductor device 100g.

Turning to Example N of FIG. 10, Example N shows a first channel 208m configured to transmit or receive a fluid 216 to or from a port 214. The first channel 208 can be configured to extend across the substrate 200 and fluidly couple to an opening 212n. The opening 212n can extend from the first channel 208n to a third channel 406n through the substrate 200, the die 300n, or the die 400n. The opening 212n can be configured to deliver fluid to various locations (e.g., active regions, other areas requiring cooling, or the like) of the die 300n. In some cases, the top surface 202 of the substrate 200 or the bottom surface 306n of the die 300m can include one or more bonding surfaces, as discussed above, the bonding surfaces can be configured to seal the first channel 208m and the opening 212n and prevent the fluid from leaking to other portions of the semiconductor device 100g. Additionally, in some cases, the top surface 314n of the die 300n or the bottom surface 404n of the die 400n can include one or more bonding surfaces, as discussed above, the bonding surfaces can be configured to seal the opening 212n or the third channel 406n and prevent the fluid from leaking to other portions of the semiconductor device 100g.

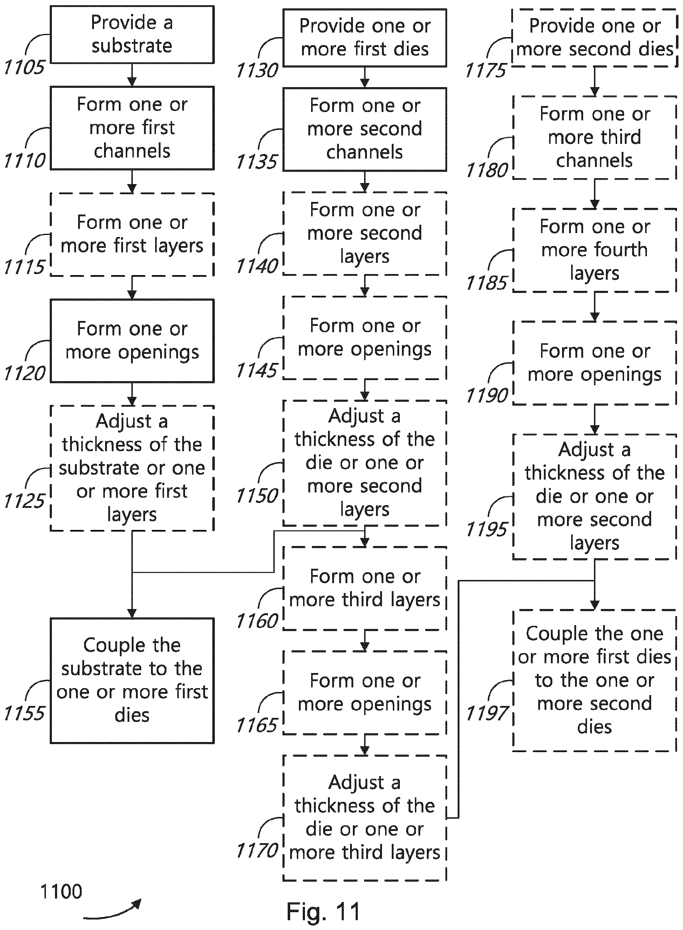

FIG. 11 is a flow diagram of a method 1100 of manufacturing a semiconductor device, in accordance with various embodiments. The method 1100 described in FIG. 11 is one way the components of FIGS. 1-10 can be manufactured. However, other methods may be used to manufacture the components of FIGS. 1-10.

Turning to FIG. 11, the method 1100 may begin, at block 1105, by providing or forming a substrate (e.g., a substrate 200, or other component of a semiconductor device comprising one or more first channels, or the like). Next, one or more first channels (e.g., first channels 208, or the like) can be formed within the first substrate at block 1110. One or more fins, ridges, or other structures or the like can be formed in the one or more first channels and can be used to separate the one or more first channels from another of the one or more first channels.

The method 1100 can further include forming one or more first layers on a surface of the substrate at optional block 1115. The one or more first layers could be one or more bonding layers or include one or more bonding surfaces as discussed above. This step is optional because the one or more first layers could instead be formed as one or more second layers on a die coupled to the substrate. In some cases, both the one or more first layers and one or more second layers could be formed. The method 1100 can further include forming or etching one or more openings (e.g., openings 212, or the like) into the substrate or the one or more first layers at optional block 1120. The one or more openings could be configured to correspond to a second channel located on one or more first die or one or more other openings formed in the one or more first dies.

The method 1100 can then continue onto optional block 1125 and include etching or adjusting a thickness or a plane of the top surface of the one or more first layers or the substrate to ensure a substantially uniform or substantially flat top surface of the one or more first layers or substrate.

The method 1100 can continue, at block 1030, by providing or forming a first row or stack (e.g., first row or stack 302 or the like) of one or more first dies (e.g., one or more die 300, or other component of a semiconductor device comprising one or more channels, or the like). In various cases, the one or more dies 300 can be formed at a same time as the substrate or at a different time. In various cases, different manufacturers or the same manufacturer could be used to manufacture the substrate and the one or more first dies.

Next, one or more second channels (e.g., second channels 312, or the like) or a portion of the one or more second channels can be formed within the one or more first dies at block 1135. One or more fins, ridges, or other structures or the like can be formed in the one or more second channels and can be used to separate the one or more second channels from another of the one or more second channels.

The method 1100 can further include optionally forming one or more second layers on a first surface of the one of the one or more first dies at optional block 1140. The first surface of the one or more first dies can be a surface that is configured to be coupled to the substrate. The one or more second layers could be one or more bonding layers or include one or more bonding surfaces as discussed above. The method 1100 can then continue onto optional block 1145 and include forming or etching one or more openings (e.g., openings 212 or the like) in the one or more second layers or one or more first dies corresponding to the openings of the one or more first layers or substrate or corresponding to the one or more first channels of the substrate.

The method can then continue onto optional block 1150 and include etching or adjusting a thickness or a plane of the surface of the one or more second layers or the one or more first dies to ensure a substantially uniform or substantially flat surface of the one or more second layers or one or more first dies. By having a substantially flat surface between the one or more first dies and the substrate, the surfaces between the one or more first dies and the substrate can be configured to seal the openings and channels between the one or more first dies and the substrate.

The one or more first dies can then be coupled to the substrate and the one or more openings or channels between the substrate and the one or more dies can be fluidly coupled together to transmit fluid between the one or more first channels and the one or more second channels at block 1155.

In various cases, when there is a second row (e.g., second row 402 or the like) of one or more second dies (e.g., second dies 400 or the like). The one or more first dies can further undergo various method steps. These steps can occur before the one or more first dies are coupled to the substrate or after the one or more first dies are coupled to the substrate. The method 1100, can continue, at optional block 1160 by forming one or more third layers on a second surface of the one or more first dies that is opposite to the first surface coupled to or configured to be coupled to the substrate. The one or more third layers could be one or more bonding layers or include one or more bonding surfaces as discussed above. The method 1100 can then continue onto optional block 1165 and include forming or etching one or more second openings (e.g., openings 322 or the like) in the one or more third layers or the one or more first dies. The one or more second openings can be configured to correspond to one or more third channels or one or more second openings of one or more second dies or the like.

The method can then continue onto optional block 1170 and include etching or adjusting a thickness or a plane of the second surface of the one or more third layers or the one or more first dies to ensure a substantially uniform or substantially flat surface of the one or more third layers or one or more first dies.

The method 1100 can continue, at block 1175, by providing or forming a second row (e.g., second row 402 or the like) of one or more second dies (e.g., one or more dies 400, or other component of a semiconductor device comprising one or more channels, or the like). In various cases, the one or more second dies can be formed at a same time as the substrate or one or more first dies or at a different time. In various cases, different manufacturers or the same manufacturer could be used to manufacture the substrate, the one or more first dies, or the one or more second dies.

Next, one or more third channels (e.g., third channels 406, or the like) or a portion of the one or more third channels can be formed within the one or more second dies at block 1180. One or more fins, ridges, or other structures or the like can be formed in the one or more third channels and can be used to separate the one or more second channels from another of the one or more third channels.

The method 1100 can further include optionally forming one or more fourth layers on a first surface of the one of the one or more second dies at optional block 1185. The first surface of the one or more second dies can be a surface that is configured to be coupled to the one or more first dies. The one or more fourth layers could be one or more bonding layers or include one or more bonding surfaces as discussed above. The method 1100 can then continue onto optional block 1190 and include forming or etching one or more openings (e.g., openings 322 or the like) in the one or more fourth layers or one or more second dies corresponding to the openings of the one or more third layers or one or more first dies or corresponding to the one or more second channels of the one or more first dies.

The method 1100 can then continue onto optional block 1195 and include etching or adjusting a thickness or a plane of the surface of the one or more fourth layers or the one or more second dies to ensure a substantially uniform or substantially flat top surface of the one or more fourth layers or one or more second dies. By having a substantially flat surface between the one or more first dies and the one or more second dies, the surfaces between the one or more first dies and the one or more second dies can be configured to seal the openings and channels between the one or more first dies and the one or more second dies.

The one or more first dies can then be coupled to the one or more second dies and the one or more openings or channels between the one or more first dies and the one or more second dies can be fluidly coupled together to transmit fluid between the one or more second channels and the one or more third channels at block 1197. This process can be repeated until a desired number of rows of dies or substrates is reached.

While some features and aspects have been described with respect to the embodiments, one skilled in the art will recognize that numerous modifications are possible. Moreover, while the procedures of the methods and processes described herein are described in a particular order for ease of description, unless the context dictates otherwise, various procedures may be reordered, added, and/or omitted in accordance with various embodiments. Moreover, the procedures described with respect to one method or process may be incorporated within other described methods or processes; likewise, system components described according to a particular structural architecture and/or with respect to one system may be organized in alternative structural architectures and/or incorporated within other described systems. Hence, while various embodiments are described with or without some features for ease of description and to illustrate aspects of those embodiments, the various components and/or features described herein with respect to a particular embodiment can be substituted, added and/or subtracted from among other described embodiments, unless the context dictates otherwise. Consequently, although several embodiments are described above, it will be appreciated that the invention is intended to cover all modifications and equivalents within the scope of the following claims.

## Claims

1. A semiconductor device comprising:
a substrate comprising a first channel;
a first die coupled to the substrate and comprising at least a first portion of a second channel; and
a first opening extending from the first channel to the second channel and fluidly coupling the first channel to the second channel.

2. The semiconductor device of claim 1, wherein:
at least one of the substrate further comprises a first layer or the first die comprises a second layer; and
wherein the first opening extends from the first channel to the second channel through at least one of the first layer or the second layer.

3. The semiconductor device of claim 2, wherein
at least one of the first layer or the second layer comprises a dielectric layer.

4. The semiconductor device of claim 2, wherein
at least one of a first surface of the first layer is coupled directly to a second surface of the first die or the second layer or a third surface of the second layer is coupled directly to a fourth surface of the substrate or the first layer.

5. The semiconductor device of any one of the claims 1 to 4, further comprising
an interface between the substrate and the first die, wherein
the interface couples a first surface of the substrate directly to a second surface of the first die and, wherein
the first opening extending from the first channel to at least the first portion of the second channel extends through the interface.

6. The semiconductor device of claim 5,
wherein the interface is formed using at least one of surface activated bonding or hybrid bonding;
or
wherein the interface is configured to form a seal surrounding the first opening extending from the first channel to at least the first portion of the second channel.

7. The semiconductor device of any one of the claims 1 to 6, further comprising
a fluid contained within the first channel and the second channel, wherein
the fluid is configured to pass from the first channel to the second channel via the first opening.

8. The semiconductor device of any one of the claims 1 to 7,
wherein the first opening is about a same size as a bottom surface of the second channel and/or
wherein the second channel is formed in the first die and a bottom surface of the second channel is a top surface of the substrate.

9. The semiconductor device of any one of the claims 1 to 8, wherein
a second portion of the second channel is at least partially formed within the substrate
and wherein the second portion of the second channel is in fluid communication with at least the first portion of the second channel.

10. The semiconductor device of any one of the claims 1 to 9, wherein
the second channel is fully contained within the first die and the first die forms a bottom surface of the second channel.

11. The semiconductor device of any one of the claims 1 to 10,
wherein the substrate further comprises another first channel,
wherein the semiconductor device further comprises a second opening,
wherein the first opening extends from the first channel to the second channel at a first location and wherein the second opening extends from the other first channel to the second channel at a second location, and
wherein the second channel bridges the first channel and the other first channel.

12. The semiconductor device of any one of the claims 1 to 11, further comprising:
a second die coupled to the first die and comprising at least a portion of a third channel, wherein the first die is between the substrate and the second die; and
a third opening extending from the first channel to the third channel through the first die or extending from the second channel to the third channel;
wherein in particular
the semiconductor device further comprises a fourth opening extending from the third channel to at least a portion of a fourth channel contained within the first die or another first die.

13. The semiconductor device of any one of the claims 1 to 12, wherein the semiconductor device further comprises
a port coupled to the first channel, the port is configured to allow fluid to flow into or out of the first channel.

14. A method of manufacturing a semiconductor device, the method comprising:
forming a substrate comprising:
forming a first channel in the substrate; and
forming a first layer on the substrate and forming a first opening extending from the first channel through the first layer;
wherein the first layer comprises an interface configured to couple directly to a surface of a die comprising at least a first portion of a second channel.

15. The method of claim 14, further comprising:
forming the die comprising:
forming at least the first portion of the second channel in the die; and
coupling the substrate to the surface of the die via the interface;
wherein the first opening extends from the first channel to the second channel and fluidly couples the first channel to the second channel.
